# EUROPÄISCHE PATENTSCHRIFT

(11) **EP 2 721 192 B1**
(45) Veröffentlichungstag und Bekanntmachung des Hinweises auf die Patenterteilung: **04.10.2017**
(21) Anmeldenummer: 12731299.9
(22) Anmeldetag: 15.06.2012
(51) Int. Cl.: C23C 16/04, C23C 16/40, C23C 16/511, C23C 16/515

(54) **VERFAHREN ZUR PLASMABEHANDLUNG VON WERKSTÜCKEN**
METHOD FOR THE PLASMA TREATMENT OF WORKPIECES
PROCÉDÉ DE TRAITEMENT DE PIÈCES PAR PLASMA

(30) Priorität: 16.06.2011 DE 102011104730
(43) Veröffentlichungstag der Anmeldung: 23.04.2014
(73) Patentinhaber: KHS Corpoplast GmbH, 22145 Hamburg (DE)
(72) Erfinder: SIEBELS, Sönke, 22303 Hamburg (DE); HERBORT, Michael, 20535 Hamburg (DE)
(74) Vertreter: Emmel, Thomas
(86) Internationale Anmeldenummer: PCT/EP2012/002551
(87) Internationale Veröffentlichungsnummer: WO 2012/171661

(56) Entgegenhaltungen:
- EP-A1- 1 911 794
- WO-A1-2012/089196
- DE-A1- 10 258 681
- DE-A1- 19 901 834
- JP-A- 2003 328 132

## Beschreibung

Die Erfindung betrifft ein Verfahren zur Plasmabehandlung von behälterartigen Werkstücken, bei dem das Werkstück in eine Plasmakammer eingesetzt wird und bei dem anschließend bei Einwirkung eines Unterdruckes nach der Zündung eines Plasmas eine Beschichtung auf dem Werkstück abgeschieden wird sowie bei dem die Zündung des Plasmas durch Mikrowellenenergie erfolgt, wobei die Beschichtung mindestens aus einer Gasbarriereschicht sowie einer zwischen dem Werkstück und der Gasbarriereschicht angeordneten Haftschicht besteht, sowie bei dem die Gasbarriereschicht SiOx und die Haftschicht Kohlenstoff enthält.

Derartige Verfahren werden beispielsweise eingesetzt, um Kunststoffe mit Oberflächenbeschichtungen zu versehen. Insbesondere sind auch bereits derartige Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Gaslanze in den Innenraum der Flaschen eingeführt, um Prozessgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozessgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde .

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittel Zuleitung durch einen Boden der Plasmakammer hindurch beschrieben.

In der DE 10 2004 020 185 A1 wird bereits eine Gaslanze beschrieben, die in den Innenraum eines zu beschichtenden Vorformlings einfahrbar ist und zur Zuleitung von Prozessgasen dient. Die Gaslanze ist in der Längsrichtung des Behälters positionierbar.

Bei der überwiegenden Anzahl der bekannten Vorrichtungen werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Derartige Barriereschichten verhindern ein Eindringen von Sauerstoff in die verpackten Flüssigkeiten sowie ein Austreten von Kohlendioxid bei CO₂-haltigen Flüssigkeiten.

In der WO 03/014412 A1 wird die Durchführung eines Plasmabeschichtungsverfahren beschrieben, bei dem die erforderliche Energieeinbringung durch gepulste Mikrowellenenergie erfolgt. Für die gesamte Durchführung des Beschichtungsvorganges wird eine geeignete Pulsbreite und Pulshöhe für die Mikrowellenenergie gewählt. Ebenfalls werden Pausenzeiten zwischen den einzelnen Impulsen festgelegt und für die Dauer der Beschichtung konstant gehalten. Variiert wird gemäß diesem Stand der Technik bei der Durchführung des Beschichtungsvorganges der Volumenstrom an zugeführten Prozessgasen sowie die Mischung der Prozessgase. Typischerweise werden die Mischungsverhältnisse und/oder die jeweiligen Volumenströme der Prozessgase zu bestimmten Zeitpunkten umgeschaltet, so dass sich ein mehrlagiger Schichtaufbau ergibt. Bei Aufbringung von Barriereschichten aus SiOx auf ein Substrat aus Kunststoff werden typischerweise zwei Schichten generiert, nämlich eine Haftschicht und die eigentliche Barriereschicht. Anwendungsabhängig kann auf der Barriereschicht noch eine zusätzliche Schutzschicht angeordnet werden.

Die DE 102 58 681 A1 offenbart ein Verfahren zur Plasmabehandlung von flaschenartigen Werkstücken, bei dem das Werkstück in eine Plasmakammer eingesetzt wird und bei dem anschließend bei Einwirkung eines Unterdruckes nach der Zündung eines gepulsten Mikrowellenplasmas eine Beschichtung auf dem Werkstück abgeschieden wird. Die Zündung des Plasmas erfolgt durch Mikrowellenenergie. Die Beschichtung besteht mindestens aus einer Gasbarriereschicht sowie aus einer zwischen der Gasbarriereschicht und dem Werkstoff angeordneten Haftschicht. Die Gasbarriereschicht enthält Siliziumoxid und die Haftschicht enthält Kohlenstoff. Die Barriereschicht wird aus einem Gas erzeugt, das mindestens eine Siliziumverbindung sowie Argon und Sauerstoff enthält.

Die EP 1 911 794 A1 offenbart ein Verfahren zur Plasmabehandlung von behälterartigen Werkstücken. Auf dem Werkstück wird eine Barriereschicht abgeschieden und auf dieser Barriereschicht eine Passivierungsschicht. Die Abscheidung der Schichten erfolgt durch ein mit Mikrowellen gepulstes plasmaunterstütztes CVD-Verfahren. Die Passivierungsschicht wird unter Verwendung von Argon im Prozessgas abgeschieden. Diese Schicht enthält auch Siliziumoxid. Zwischen dem Werkstoff und der Barriereschicht ist eine Kohlenstoff enthaltende Haftschicht angeordnet.

Die DE 199 01 834 A1 betrifft ein Verfahren zum Beschichten von Substraten aus Kunststoff. Das Verfahren wird in einer Vakuumkammer ausgeführt mittels Anwendung eines Plasmas. Zur Erzeugung einer Sperrschicht wird ein oxidierendes Gas und eine siliziumorganische Verbindung benutzt. Beschichtet werden Platten aus Polycarbonat zur Verbesserung der Kratzfestigkeit, der Abriebunempfindlichkeit und zum Schutz gegen Witterungseinflüsse.

Die JP 2003-328132 A offenbart ein Mikrowellenplasma unterstütztes CVD-Verfahren zum Abscheiden von Siliziumoxidbarriereschichten auf der Innenseite eines Kunststoffbehälters. Das Prozessgas enthält HMDSO, Sauerstoff und Argon.

Typischerweise enthalten die verwendeten Prozessgase beispielsweise HMDSO oder HMDSN zur Bereitstellung des Siliziums und Sauerstoff als oxidierendes Gas. Die Eigenschaften der jeweils abgeschiedenen Schicht und insbesondere der Kohlenstoffanteil wird durch die Menge des zugeführten Sauerstoffes und/oder die Art und Weise der Einbringung der Mikrowellenenergie gesteuert.

Im Hinblick auf die aufgebrachten Barriereschichten können die bisherigen Verfahren noch nicht alle Anforderungen erfüllen. Insbesondere zeigt es sich, dass die bislang bekannten Barriereschichten empfindlich gegenüber von Dehnungen der beschichteten Behälter sind. Entsprechende Dehnungen können beispielsweise durch einen Innendruck bei der Befüllung der Behälter, durch einen Innendruck von befüllten Behältern bei einer Befüllung mit karbonisierten Getränken oder durch äußere mechanische Belastungen des leeren oder des befüllten Behälters erzeugt werden. Derartige Belastungen können zu einer Entstehung von Rissen innerhalb der Barriereschicht oder zu einem Risswachstum führen. Derartige Risse beeinträchtigen deutlich die Gasdichtigkeit der erzeugten Barriereschicht.

Die entsprechende Generierung derartiger Risse kann im Rahmen eines sogenannten Creep-Testes simuliert werden.

Aufgabe der vorliegenden Erfindung ist es, ein Verfahren der einleitend genannten Art derart zu verbessern, dass die Eigenschaften der Barriereschicht verbessert werden.

Diese Aufgabe wird erfindungsgemäß dadurch gelöst, dass die Barriereschicht aus einem Gas erzeugt wird, das mindestens eine Siliziumverbindung sowie Argon und Sauerstoff enthält, gemäß der Angaben in Patentanspruch 1. Besondere Ausführungsarten der Erfindung sind in den Patentansprüchen 2-8 angegeben. Durch die Verwendung von Argon als ein Prozessgas bei der Erzeugung der Barriereschicht wird Sauerstoff zumindest teilweise substituiert bzw. es wird zumindest die Sauerstoffmenge verringert. Es zeigt sich, dass die Barriereschicht sowohl hinsichtlich ihrer Beständigkeit gegenüber von äußeren mechanischen Einwirkungen als auch hinsichtlich weiterer Eigenschaften gegenüber dem Stand der Technik verbessert ist.

Durch die Verwendung von Argon als Prozessgas kann erreicht werden, dass die erzeugten Barriereschichten gegenüber dem Stand der Technik eine höhere Dichte aufweisen und mit einem homogeneren Wachstum versehen sind. Ein derartiger Aufbau vermeidet oder verringert die Rissbildung bei einwirkenden mechanischen Belastungen, darüber hinaus zeigt es sich, dass für den dennoch eintretenden Fall einer Rissbildung die Anzahl der Risse gegenüber dem Stand der Technik geringer ist.

Ein erfindungsgemäßer Arbeitsbereich wird dadurch definiert, dass das Argon in einem Anteil von 10 bis 60 Elementprozent im gesamten Prozessgas enthalten ist.

Eine gleichmäßige Struktur der Barriereschicht wird erfindungsgemäß dadurch unterstützt, dass sowohl Argon als auch Sauerstoff im gesamten Prozessgas enthalten sind, wobei das Sauersoff mit einem Anteil von 39 bis 89 Elementprozent im Prozessgas enthalten ist.

Gemäß einer typischen Prozeßvariante ist daran gedacht, dass als ein Prozessgas HMDSO verwendet wird.

Gemäß einer anderen Prozeßvariante ist es auch möglich, dass als ein Prozessgas HMDSN verwendet wird.

Eine Steuerbarkeit des Prozesses wird dadurch unterstützt, dass zur Zündung des Plasmas eine gepulste Mikrowelle verwendet wird.

Eine einfache Prozeßdurchführung kann dadurch erreicht werden, dass während der Erzeugung der Barriereschicht die Prozessgase mit einem zeitlich im Wesentlichen konstanten Volumenstrom zugeführt werden.

Insbesondere ist daran gedacht, dass das Argon in einem Anteil von 30 bis 50 Elementprozent im gesamten Prozessgas enthalten ist.

Als besonders vorteilhaft erweist es sich, dass das Argon in einem Anteil von 36 bis 44 Elementprozent im gesamten Prozessgas enthalten ist.

Das erfindungsgemäße Verfahren ist insbesondere dafür geeignet, den Ablauf eines Beschichtungsverfahrens für Flaschen aus Kunststoff zu beeinflussen. Es erfolgt hierbei insbesondere eine Innenbeschichtung dieser Flaschen mit einer Schicht aus SiOx, wobei die Haftung der Schicht aus SiOx auf dem Kunststoff durch eine Zwischenschicht verbessert werden kann, die als ein Haftvermittler ausgebildet ist. Das Beschichtungsverfahren wird vorzugsweise als ein PICVD-Plasmaprozess durchgeführt (Plasma impuls induced chemical vapour deposition). Bei einem derartigen Verfahren wird das Plasma unter Verwendung von Pulsen einer Mikrowelle gezündet. Die Pulse können hinsichtlich ihrer Pulsbreite, des Pulsabstandes sowie der Pulshöhe gesteuert werden.

In den Zeichnungen sind Ausführungsbeispiele der Erfindung schematisch dargestellt. Es zeigen:

Insbesondere ist daran gedacht, dass das Argon in einem Anteil von 30 bis 50 Elementprozent im gesamten Prozessgas enthalten ist.

Als besonders vorteilhaft erweist es sich, dass das Argon in einem Anteil von 36 bis 44 Elementprozent im gesamten Prozessgas enthalten ist.

Eine gleichmäßige Struktur der Barriereschicht wird dadurch unterstützt, dass sowohl Argon als auch Sauerstoff im gesamten Prozessgas enthalten sind.

Insbesondere ist daran gedacht, das Sauersoff mit einem Anteil von 39 bis 89 Elementprozent im Prozessgas enthalten ist.

Das erfindungsgemäße Verfahren ist insbesondere dafür geeignet, den Ablauf eines Beschichtungsverfahrens für Flaschen aus Kunststoff zu beeinflussen. Es erfolgt hierbei insbesondere eine Innenbeschichtung dieser Flaschen mit einer Schicht aus SiOx, wobei die Haftung der Schicht aus SiOx auf dem Kunststoff durch eine Zwischenschicht verbessert werden kann, die als ein Haftvermittler ausgebildet ist. Das Beschichtungsverfahren wird vorzugsweise als ein PICVD-Plasmaprozess durchgeführt (Plasma impuls induced chemical vapour deposition). Bei einem derartigen Verfahren wird das Plasma unter Verwendung von Pulsen einer Mikrowelle gezündet. Die Pulse können hinsichtlich ihrer Pulsbreite, des Pulsabstandes sowie der Pulshöhe gesteuert werden.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabeund Ausgaberädern gekoppelt ist,
- Fig. 2: eine Anordnung ähnlich zu Fig. 1, bei der die Plasmastationen jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine teilweise Darstellung eines Querschnittes durch ein Substrat mit einer Barriereschicht,
- Fig. 8: eine erste Tabelle zur Veranschaulichung unterschiedlicher Varianten zur Durchführung des Beschichtungsprozeßes mit Prozeßdaten zur Erzeugung der Barriereschicht,
- Fig. 9: Prozeßdaten zur Erzeugung eines Haftvermittlers für die Prozeßvarianten gemäß Fig. 8,
- Fig. 10: ein Diagramm zur Gegenüberstellung von Barriereeigenschaften von Barriereschichten, die durch die unterschiedliche Prozessgaszusammensetzungen gemäß Fig. 8 abgeschieden wurden, jeweils für einen unbelasteten Grundzustand sowie nach einer mechanischen Belastung der Barriereschicht.

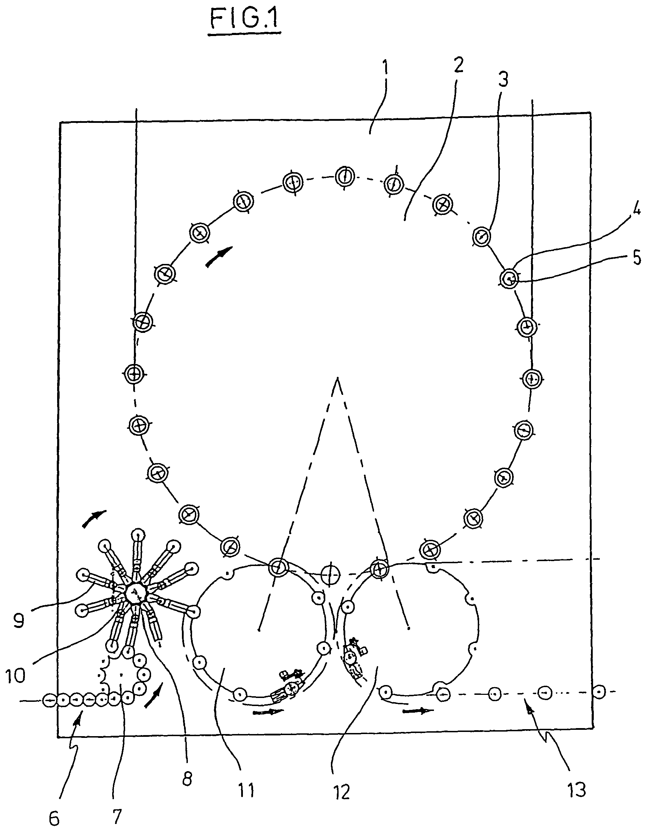

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so dass eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

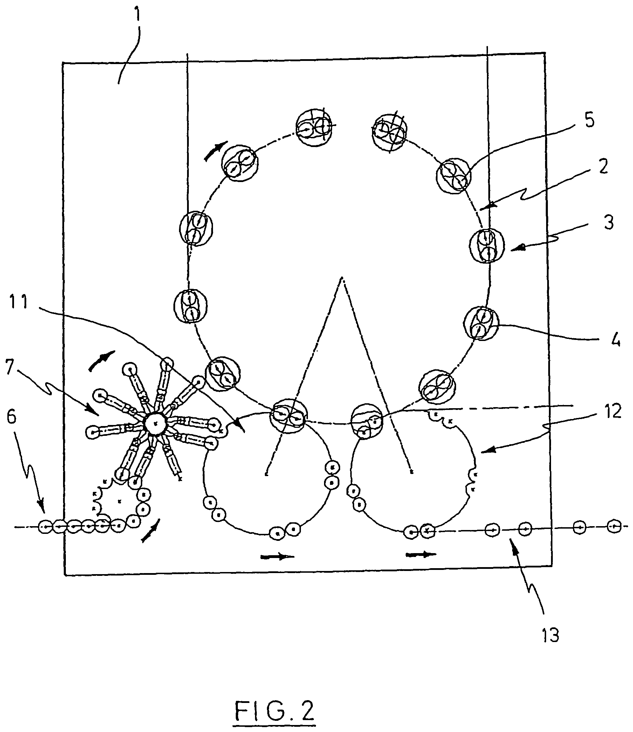

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, dass eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

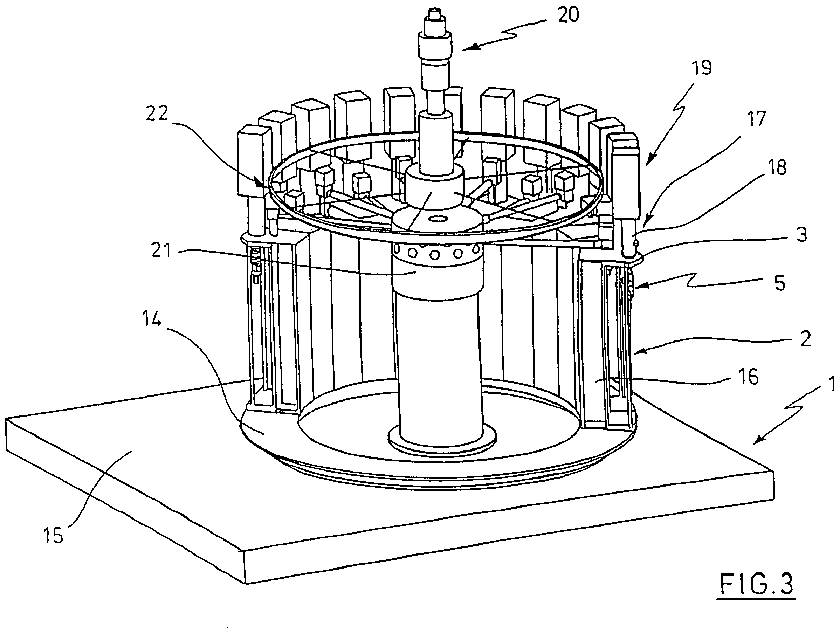

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

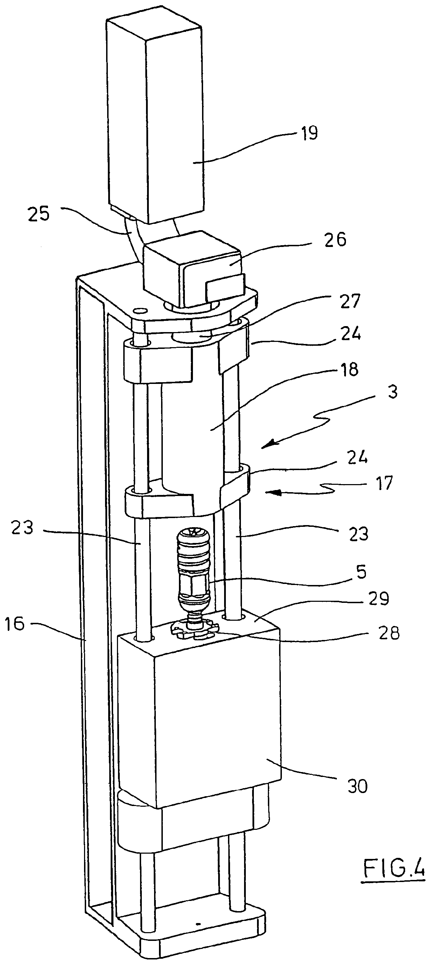

Fig. 4 zeigt eine Plasmastation (3) in perspektivischer Darstellung. Es ist zu erkennen, dass der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so dass das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdeckels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird von einem Halteelement (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

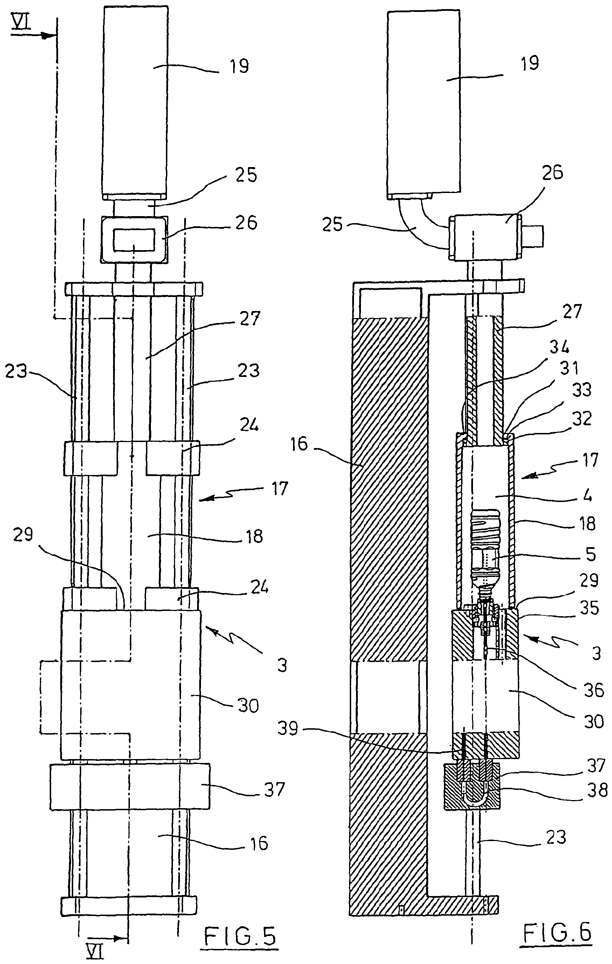

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so dass die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, dass der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so dass sowohl ein Innenraum der Kavität (4) als auch ein Innenraum des Werkstückes (5) evakuiert werden können. Zur Unterstützung einer Zuleitung von Prozessgas ist im Bereich des Kammersockels (30) eine hohle Gaslanze (36) angeordnet, die in den Innenraum des Werkstückes (5) hineinverfahrbar ist. Zur Durchführung einer Positionierung der Gaslanze (36) wird diese von einem Lanzenschlitten (37) gehaltert, der entlang der Führungsstangen (23) positionierbar ist. Innerhalb des Lanzenschlittens (37) verläuft ein Prozessgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

Alternativ zur vorstehend erläuterten Konstruktion der Plasmastation ist es erfindungsgemäß aber auch möglich, das Werkstück (5) in eine relativ zur zugeordneten Tragstruktur unbewegliche Plasmakammer (17) einzuführen. Ebenfalls ist es möglich, alternativ zur dargestellten Beschichtung der Werkstücke (5) mit ihren Mündungen in lotrechter Richtung nach unten eine Beschichtung der Werkstücke mit ihren Mündungen in lotrechter Richtung nach oben durchzuführen. Insbesondere ist daran gedacht, eine Beschichtung von flaschenförmigen Werkstücken (5) durchzuführen. Derartige Flaschen sind ebenfalls bevorzugt aus einem thermoplastischen Kunststoff ausgebildet. Vorzugsweise ist an die Verwendung von PET oder PP gedacht. Gemäß einer weiteren bevorzugten Ausführungsform dienen die beschichteten Flaschen zur Aufnahme von Getränken.

Ein typischer Behandlungsvorgang wird im folgenden am Beispiel eines Beschichtungsvorganges erläutert und derart durchgeführt, dass zunächst das Werkstück (5) unter Verwendung des Eingaberades (11) zum Plasmarad (2) transportiert wird und dass in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Halteelementes (28) eine Abschottung des Innenraumes des Werkstückes (5) gegenüber dem Innenraum der Kavität (4) durchgeführt. Ebenfalls ist es möglich, die Gaslanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Gaslanze (36) wenigstens teilweise bereits parallel zur Positionierung der Kammerwandung (18) durchzuführen. Nach Erreichen eines ausreichend tiefen Unterdruckes wird Prozessgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Gaslanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen.

Eine Positionierung der Kammerwandung (18), des Dichtelementes (28) und / oder der Gaslanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, dass entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

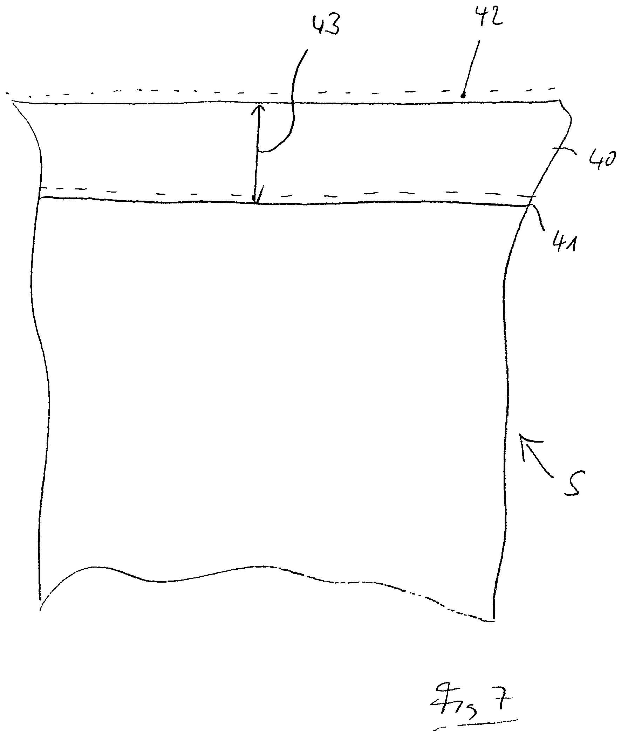

Fig. 7 zeigt eine teilweise Darstellung eines vergrößerten Querschnittes durch ein Werkstück (5), das mit einer Barriereschicht (40) versehen ist. Typischerweise ist die Barriereschicht (40) auf einer Wandung eines flaschenförmigen Behälters angeordnet. Insbesondere besteht das Werkstück (5) aus PET. Vorzugsweise ist die Barriereschicht (40) über eine Haftschicht (41) mit dem Werkstück (5) verbunden. Darüber hinaus ist es möglich, die Barriereschicht (40) im Bereich ihrer dem Werkstück (5) abgewandten Ausdehnung mit einer Schutzschicht (42) zu versehen.

Grundsätzlich können die Haftschicht (41) und/oder die Schutzschicht (42) als von der Barriereschicht (40) abgegrenzte Schichten ausgebildet sein, insbesondere ist aber daran gedacht, sogenannte Gradientenschichten zu realisieren, bei denen eine schichtartige Wirkung durch eine Veränderung der elementaren Zusammensetzung über eine Schichtdicke (43) erreicht wird. Hierdurch werden sogenannte Gradientenschichten bereitgestellt. Betroffen von der Änderung der elementaren Zusammensetzung ist mindestens eines der chemischen Elemente Kohlenstoff, Silizium sowie Sauerstoff. Grundsätzlich können aber auch andere chemische Elemente zusätzlich oder alternativ verwendet werden.

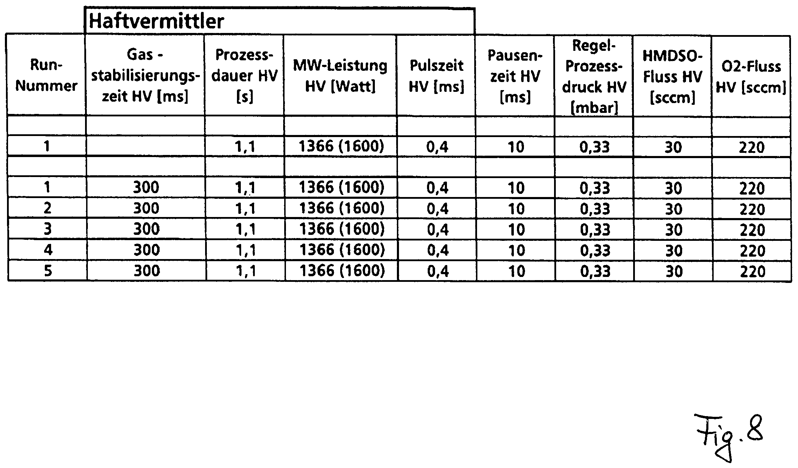

Fig. 8 zeigt für fünf verschiedene Proben unterschiedliche Prozeßparameter. Für die Probennummer 1 wird ein Prozeß durchgeführt, bei dem die Barriereschicht (40) bei Anwesenheit von Sauerstoff als Prozessgas abgeschieden wird. Für die Probennummern 2 bis 5 wird die Barriereschicht (40) bei Anwesenheit von Sauerstoff und Argon abgeschieden.

Die Erzeugung der Barriereschicht (40) erfolgt bei den veranschaulichten Beispielen sowohl bei Anwesenheit von Sauerstoff als auch bei Anwesenheit von Argon. Die letzte Spalte der Tabelle gibt hierbei den Anteil von Argon an der gesamten Prozessgasmenge wieder.

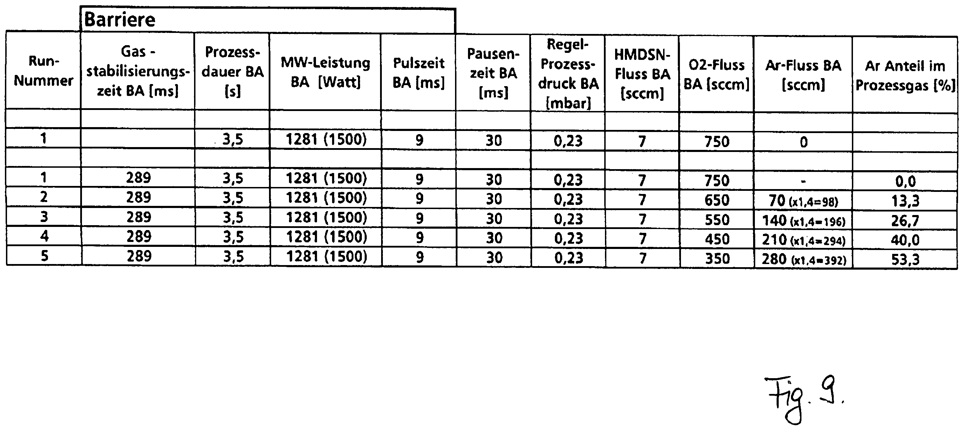

Fig. 9 zeigt für die Probennummern gemäß Fig. 8 die Prozeßparameter für die Aufbringung der Haftschicht (41). Die Pulszeiten beziehen sich hierbei auf die Pulsbreite der gezündeten Mikrowellenimpulse und die Pausenzeiten auf die Abstände zwischen den einzelnen Mikrowellenimpulsen. Eingetragen sind ebenfalls die Mikrowellenleistung sowie der anliegende Prozeßdruck. Ebenfalls ist der Fluß für HMDSO sowie für Sauerstoff aufgelistet.

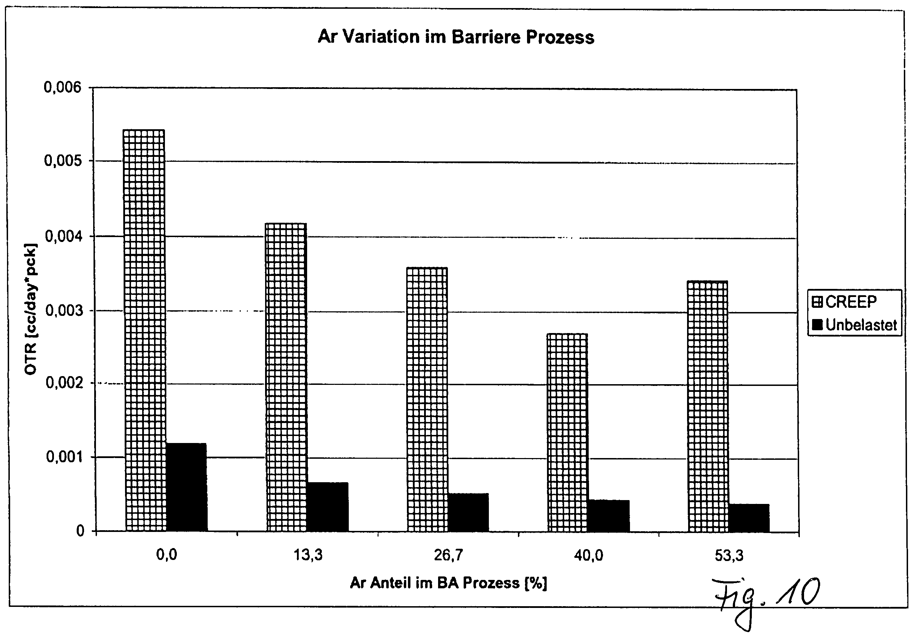

Fig. 10 stellt als Balkendiagramm die Barriereeigenschaften der Proben gemäß Fig. 8 zusammen. Es ist zu erkennen, dass die Barriereeigenschaften bei einer Abscheidung der Barriereschicht (40) bei Anwesenheit von Argon deutlich besser sind als die Barriereeigenschaften einer Abscheidung der Schutzschicht (42) bei Anwesenheit nur von Sauerstoff.

Die funktionellen Eigenschaften der Haftschicht (41) und/oder der Schutzschicht (42) werden durch eine Änderung der elementaren Zusammensetzung erreicht. Typischerweise liegt der Kohlenstoffanteil in Elementprozent im Bereich der funktionellen Haftschicht (41) und/oder der funktionellen Schutzschicht (42) im Bereich von 10 - 60 Elementprozent. Bevorzugt ist für die Schutzschicht (42) ein Wert von etwa 30 bis 60 Elementprozent. Der Kohlenstoffanteil im Bereich der funktionellen Barriereeigenschaften beträgt etwa 5 Elementprozent.

Bei allen vorstehend beschriebenen Ausführungsbeispielen ist insbesondere auch daran gedacht, zusätzlich zum Argon mindestens ein weiteres Edelgas zu verwenden oder das Argon durch mindestens ein anderes Edelgas zu substituieren.

Aus der Tabelle in Fig. 8 ist zu erkennen, dass im Prozessgas, das aus der Silizium enthaltenden Komponente und Sauerstoff sowie Argon besteht, ein deutlicher Überschuss von Sauerstoff gegeben ist. An der Menge des gesamten Prozessgases macht der Anteil des Silizium enthaltenden Prozessgases nur etwa 1 Prozent aus. Dies unterstützt eine gleichmäßige Ausbildung der Barriereschicht, darüber hinaus werden ausreichend hohe Strömungsgeschwindigkeiten des Prozessgases gewährleistet, um eine gleichmäßige Verteilung der Prozessgase innerhalb des zu beschichtenden Behälters zu erreichen.

Der erfindungsgemäße Beschichtungsprozess wird typischerweise mit einem Anteil des Silizium enthaltenden Prozessgases am gesamten Prozessgas von etwa 0,7 Elementprozent bis 1,2 Elementprozent durchgeführt. Anwendbar ist auch noch ein Bereich von 0,5 Elementprozent bis 1,5 Elementprozent.

## Patentansprüche

1. Verfahren zur Plasmabehandlung von behälterartigen Werkstücken, bei dem das Werkstück in eine Plasmakammer eingesetzt wird und bei dem anschließend bei Einwirkung eines Unterdruckes nach der Zündung eines Plasmas eine Beschichtung auf dem Werkstück abgeschieden wird sowie bei dem die Zündung des Plasmas durch Mikrowellenenergie erfolgt, wobei die Beschichtung mindestens aus einer Gasbarriereschicht sowie einer zwischen dem Werkstoff und der Gasbarriereschicht angeordneten Haftschicht besteht, sowie bei dem die Gasbarriereschicht SiOx und die Haftschicht Kohlenstoff enthält, **dadurch gekennzeichnet, dass** die Barriereschicht (40) aus einem Gas erzeugt wird, das mindestens eine Siliziumverbindung sowie Argon und Sauerstoff enthält, wobei das Argon in einem Anteil von 10 bis 60 Elementprozent im gesamten Prozessgas enthalten ist, wobei der Sauerstoff mit einem Anteil von 39 bis 89 Elementprozent im gesamten Prozessgas enthalten ist, und das Silizium enthaltende Prozessgas bei einem Anteil von etwa 1 Elementprozent im gesamten Prozessgas enthalten ist, wobei dieser Anteil 0,5 bis 1,5 Elementprozent beträgt.

2. Verfahren nach Anspruch 1, **dadurch gekennzeichnet, dass** als ein Prozessgas HMDSO verwendet wird.

3. Verfahren nach Anspruch 1, **dadurch gekennzeichnet, dass** als ein Prozessgas HMDSN verwendet wird.

4. Verfahren nach einem der Ansprüche 1 bis 3, **dadurch gekennzeichnet, dass** zur Zündung des Plasmas eine gepulste Mikrowelle verwendet wird.

5. Verfahren nach einem der Ansprüche 1 bis 4, **dadurch gekennzeichnet, dass** während der Erzeugung der Barriereschicht (40) die Prozessgase mit einem zeitlich im Wesentlichen konstanten Volumenstrom zugeführt werden.

6. Verfahren nach einem der Ansprüche 1 bis 4, **dadurch gekennzeichnet, dass** das Argon in einem Anteil von 30 bis 50 Elementprozent im gesamten Prozessgas enthalten ist.

7. Verfahren nach einem der Ansprüche 1 bis 4, **dadurch gekennzeichnet, dass** das Argon in einem Anteil von 36 bis 44 Elementprozent im gesamten Prozessgas enthalten ist.

8. Verfahren nach Anspruch 1, **dadurch gekennzeichnet, dass** das Silizium enthaltende Prozessgas bei einem Anteil von etwa 1 Elementprozent im gesamten Prozessgas enthalten ist, wobei dieser Anteil 0,7 bis 1,3 Elementprozent beträgt.

## Claims

1. A method for the plasma treatment of container-like workpieces, in which the workpiece is inserted into a plasma chamber and in which subsequently a coating is deposited on the workpiece under the effect of vacuum pressure after a plasma has been ignited, and in which the ignition of the plasma is achieved by means of microwave energy, wherein the coating consists at least of a gas barrier layer and an adherent layer arranged between the material and the gas barrier layer, and in which the gas barrier layer contains SiOx and the adherent layer contains carbon, **characterised in that**
- the barrier layer (40) is generated from a gas which contains at least one silicon component as well as argon and oxygen, wherein the argon is contained in the entire process gas with a content of 10 to 60 per cent by element, wherein the oxygen is contained in the entire process gas with a content of 39 to 89 per cent by element, and wherein the silicon-containing process gas is contained in the entire process gas with a content of about 1 per cent by element, wherein this content is 0.5 to 1.5 per cent by element.

2. The method in accordance with Claim 1, **characterised in that** HMDSO is used as process gas.

3. The method in accordance with Claims 1, **characterised in that** HMDSN is used as process gas.

4. The method in accordance with any one of Claims 1 to 3, **characterised in that** a pulsed microwave is used to ignite the plasma.

5. The method in accordance with any one of Claims 1 to 4, **characterised in that**, while the barrier layer (40) is being generated, the process gases are supplied with a volume flow that is, in essence, constant in terms of time.

6. The method in accordance with any one of Claims 1 to 4, **characterised in that** the argon is contained in the entire process gas with a content of 30 to 50 per cent by element.

7. The method in accordance with any one of Claims 1 to 4, **characterised in that** the argon is contained in the entire process gas with a content of 36 to 44 per cent by element.

8. The method in accordance with Claims 1, **characterised in that** the silicon-containing process gas is contained in the entire process gas with a content of about 1 per cent by element, wherein this content is 0.7 to 1.3 per cent by element.

## Revendications

1. Procédé de traitement au plasma de pièces de type récipient dans le cadre duquel la pièce est introduite dans une chambre à plasma après quoi, sous l'effet d'une dépression après l'amorçage d'un plasma, un revêtement est déposé sur la pièce, et dans le cadre duquel l'amorçage du plasma a lieu par énergie micro-ondes, le revêtement étant au moins composé d'une couche formant barrière au gaz ainsi que d'une couche d'adhésion agencée entre le matériau et la couche formant barrière au gaz, et dans le cadre duquel la couche formant barrière au gaz contient du SiOx et la couche d'adhésion du carbone, **caractérisé en ce que** la couche formant barrière (40) est produite à partir d'un gaz qui contient au moins un composé de silicium ainsi que de l'argon et de l'oxygène, l'argon étant contenu pour une part de 10 à 60 pour-cent d'élément dans la totalité du gaz de procédé et l'oxygène étant contenu pour une part de 39 à 89 pour-cent d'élément dans la totalité du gaz de procédé, et le gaz de procédé contenant du silicium étant contenu pour une part d'environ 1 pour-cent d'élément dans la totalité du gaz de procédé, cette part étant de 0,5 à 1,5 pour-cent d'élément.

2. Procédé selon la revendication 1, **caractérisé en ce qu'** un gaz de procédé utilisé est du HMDSO.

3. Procédé selon la revendication 1, **caractérisé en ce qu'** un gaz de procédé utilisé est du HMDSN.

4. Procédé selon l'une des revendications 1 à 3, **caractérisé en ce qu'** une micro-onde pulsée est utilisée pour l'amorçage du plasma.

5. Procédé selon l'une des revendications 1 à 4, **caractérisé en ce que**, pendant la production de la couche formant barrière (40), les gaz de procédé sont amenés avec un débit volumétrique essentiellement constant dans le temps.

6. Procédé selon l'une des revendications 1 à 4, **caractérisé en ce que** l'argon est contenu pour une part de 30 à 50 pour-cent d'élément dans la totalité du gaz de procédé.

7. Procédé selon l'une des revendications 1 à 4, **caractérisé en ce que** l'argon est contenu pour une part de 36 à 44 pour-cent d'élément dans la totalité du gaz de procédé.

8. Procédé selon la revendication 1, **caractérisé en ce que** le gaz de procédé contenant du silicium est contenu pour une part d'environ 1 pour-cent d'élément dans la totalité du gaz de procédé, cette part étant de 0,5 à 1,5 pour-cent d'élément.
